# EUROPEAN PATENT APPLICATION

(11) **EP 4 590 106 A1**
(43) Date of publication of application: **23.07.2025**
(21) Application number: 23923427.1
(22) Date of filing: 24.02.2023
(51) Int. Cl.: H10K 85/60

(54) **PRECURSOR, PEROVSKITE LIGHT ABSORPTION LAYER AND PREPARATION METHOD, PEROVSKITE BATTERY, AND ELECTRIC DEVICE**

(71) Applicant: Contemporary Amperex Future Energy Research Institute (Shanghai) Limited, Shanghai 200241 (CN); Contemporary Amperex Technology Co., Limited, Ningde, Fujian 352100 (CN); Shanghai Jiao Tong University, Shanghai 200240 (CN)
(72) Inventor: CHEN, Junchao, Shanghai 201100 (CN); ZHANG, Zhanfei, Shanghai 201100 (CN); CHEN, Chen, Shanghai 201100 (CN); CHEN, Guodong, Shanghai 201100 (CN); GUO, Yongsheng, Shanghai 201100 (CN)
(74) Representative: Ziebig Hengelhaupt Intellectual Property Attorneys Patentanwaltskanzlei PartGmbB
(86) International application number: PCT/CN2023/078234
(87) International publication number: WO 2024/174251

(57) **Abstract**

Embodiments of this application provide a precursor, a perovskite light-absorbing layer and preparation method thereof, a perovskite battery, and an electric device. The precursor is used for preparing a perovskite light-absorbing layer and includes a perovskite precursor solution and an organic additive added to the perovskite precursor solution, where the organic additive includes one or more functional groups of a carboxyl group, a hydroxyl group, and an amino group. In this application, the organic additive including one or more functional groups of the carboxyl group, the hydroxyl group, and the amino group is added to the perovskite precursor solution, alleviating problems such as a crystallization defect and uneven crystal grain distribution of a perovskite component in the process of the perovskite precursor solution forming perovskite, thereby improving the photoelectric conversion efficiency and stability of the perovskite battery.

## Description

### TECHNICAL FIELD

This application relates to the field of battery technologies, and in particular to a precursor, a perovskite light-absorbing layer and preparation method thereof, a perovskite battery, and an electric device

### BACKGROUND

Organic metal halide perovskite batteries have attracted widespread attention from researchers worldwide due to their good photoelectric conversion potential and low manufacturing costs. After more than a decade of research and development, their highest photoelectric conversion efficiency has reached 25.7%.

However, in the high-efficiency organic metal halide perovskite batteries, the commonly used metal element is the heavy metal element lead (Pb), whose severe pollution contradicts the high-efficiency and low-pollution development trend required for solar batteries. Therefore, it is necessary to develop new environmentally friendly perovskite batteries while ensuring high photoelectric conversion efficiency and stability.

### SUMMARY

The main technical problem resolved by this application is the deteriorating effect of intrinsic defects, in the formation process of a lead-tin mixed perovskite light-absorbing layer, on the photoelectric conversion efficiency and stability of the perovskite battery.

According to a first aspect, a precursor for preparing a perovskite light-absorbing layer includes:
a perovskite precursor solution and an organic additive added to the perovskite precursor solution,
where the organic additive includes one or more functional groups of 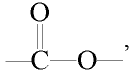 -OH, and -NH2 .

In one or more embodiments of this application, the organic additive including one or more functional groups of the carboxyl group, the hydroxyl group, and the amino group is added to the perovskite precursor solution, alleviating problems such as a crystallization defect and uneven crystal grain distribution of a perovskite component in the process of the perovskite precursor solution forming perovskite, thereby improving the photoelectric conversion efficiency and stability of the perovskite battery.

In some embodiments, the perovskite precursor solution includes a lead-tin mixed perovskite precursor solution.

In this application, the "lead-tin mixed perovskite precursor solution" refers to a precursor material for forming a lead-tin mixed perovskite material.

In one or more embodiments of this application, the organic additive including one or more functional groups of the carboxyl group, the hydroxyl group, and the amino group is added to the lead-tin mixed perovskite precursor solution, alleviating problems such as an intrinsic defect of Sn²⁺ being easily oxidized to Sn⁴⁺, a tin vacancy defect caused by introduction of the element tin, a crystallization defect of a tin-based perovskite component, and uneven crystal grain distribution of a tin-lead-based perovskite component, thereby improving the photoelectric conversion efficiency and stability of the perovskite battery.

Specifically, the organic additive including one or more functional groups of the carboxyl group, the hydroxyl group, and the amino group interacts strongly with the tin-based component in the lead-tin mixed perovskite precursor, suppressing impurities in the intermediate phase, reducing the crystal growth rate, and ultimately obtaining a lead-tin mixed perovskite light-absorbing layer without holes and wrinkles, thereby improving the photoelectric conversion efficiency and stability of the perovskite battery.

In some embodiments, the organic additive includes two functional groups 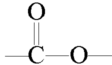 and -QH , or two functional groups 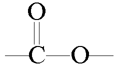 and -NH₂.

In one or more embodiments of this application, the organic additive includes the foregoing functional groups, to increase the degree of binding and/or coordination between the organic additive and the tin-based component in the perovskite precursor solution, thereby delaying the crystallization process of the lead-tin mixed perovskite and/or passivating defects, forming a high-quality perovskite light-absorbing layer.

In some embodiments, a structural formula of the organic additive includes 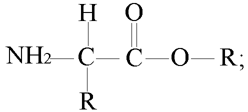 where R includes at least one of H, CH₃, or C₂H₅.

In one or more embodiments of this application, a chain-structured organic additive is added to the perovskite precursor solution, improving the quality of the formed perovskite light-absorbing layer. Specifically, in one or more embodiments of this application, the organic additive is organic small molecule amine, which can interact strongly with the tin-based component in the lead-tin mixed perovskite precursor, thereby reducing the crystallization rate of the tin-based perovskite component.

In some embodiments, the structural formula of the organic additive includes one or more of

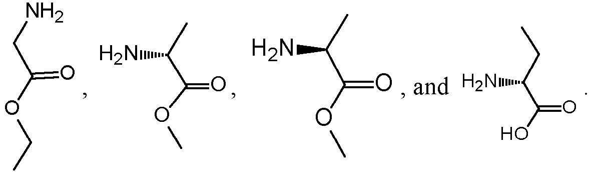

In one or more embodiments of this application, several preferred organic small molecule additives are provided to improve the quality of the perovskite light-absorbing layer. Specifically, the several organic additives provided in one or more embodiments of this application are isomers of C₄H₉O₂N and all have a chain structure.

In some embodiments, a structural formula of the organic additive includes 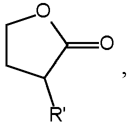 where R' includes NH₂ or OH.

In one or more embodiments of this application, a cyclic-structured organic additive is added to the perovskite precursor solution, improving the quality of the formed perovskite light-absorbing layer. Specifically, in one or more embodiments of this application, the organic additive is heterocyclic-structured organic small molecule amine or organic small molecule hydroxyl ester. The strong interaction between the amino group or hydroxyl group of the organic additive and the tin-based component in the lead-tin mixed perovskite precursor reduces the crystallization rate of the tin-based perovskite component.

In some embodiments, the structural formula of the organic additive includes one or more of

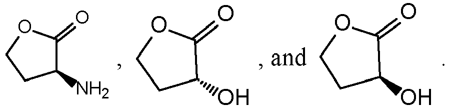

In one or more embodiments of this application, several organic small molecule additives are provided to improve the quality of the perovskite light-absorbing layer. Specifically, the several organic additives provided in one or more embodiments of this application all have oxygen-containing five-membered rings and are aliphatic.

In some embodiments, the structural formula of the organic additive includes one or more of

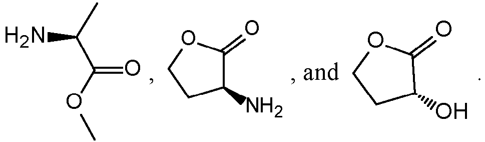

In one or more embodiments of this application, the foregoing several organic additives reduce the oxidation of Sn²⁺ to Sn⁴⁺, the formation of the tin vacancy defect, and the crystallization rate of the tin-based perovskite component, and improve the quality of the formed perovskite light-absorbing layer, thereby improving the photoelectric conversion efficiency and stability of the perovskite battery.

In some embodiments, the structural formula of the organic additive includes one or more of

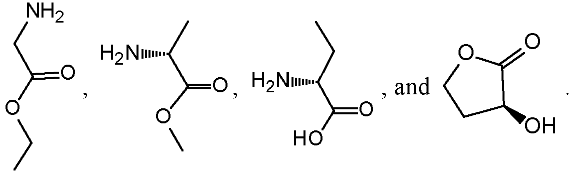

In one or more embodiments of this application, the foregoing several organic additives further improve the quality of the formed perovskite light-absorbing layer, significantly improving the photoelectric conversion efficiency and stability of the perovskite battery.

In some embodiments, a molar amount of the organic additive is 0.1%-10% of a molar amount of the perovskite precursor solution.

In one or more embodiments of this application, a proportion of the molar amount of any organic additive that can improve the quality of the formed perovskite light-absorbing layer to the molar amount of the perovskite precursor solution is within the protection scope of this application. In one or more embodiments, the molar amount of the organic additive is within the range of 0.1%-10% of the molar amount of the perovskite precursor solution, resulting in a high-quality perovskite light-absorbing layer, and effectively improving the photoelectric conversion efficiency and stability of the perovskite battery.

According to a second aspect, this application provides a perovskite light-absorbing layer, which is prepared from any precursor provided in the first aspect.

In one or more embodiments of this application, the titanium ore light-absorbing layer is prepared from the precursor provided in the first aspect, resulting in improved photoelectric conversion efficiency and stability, thereby prolonging the service life of the perovskite battery including such layer and broadening the application prospect.

In some embodiments, a material of the perovskite light-absorbing layer is Cs_{(0-0.05)}FA_{(0.8-0.95)}MA_{(0-0.10)}Pb_{(0.5-1.0)}SN_{(0.3-0.6)}I₃.

In one or more embodiments of this application, the provided organic additive is added to the perovskite precursor solution, such that the organic additive interacts strongly with the tin-based component therein, suppressing impurities in the intermediate phase, and reducing the crystal growth rate, to obtain a perovskite light-absorbing layer without holes and wrinkles, thereby improving the photoelectric conversion efficiency and stability of the perovskite battery.

In some embodiments, a material of the perovskite light-absorbing layer is Cs_{0.05}FA_{0.90}MA_{0.05}Pb_{0.6}Sn_{0.4}I₃.

In one or more embodiments of this application, a perovskite battery is made of lead-tin mixed perovskite with a specific Sn doping amount. This reduces pollution of the lead-based perovskite battery, decreases intrinsic defects, improves film quality, and ensures that the photoelectric conversion efficiency and stability of the formed perovskite battery remain at a high level. Additionally, during the formation of Cs_{0.05}FA_{0.90}MA_{0.05}Pb_{0.6}Sn_{0.4}I₃, the organic additive provided in this application is added, further improving the photoelectric conversion efficiency and stability of the perovskite battery, such that the perovskite battery provided in this application has significantly improved photoelectric conversion efficiency and stability.

According to a third aspect, this application provides a preparation method of a perovskite light-absorbing layer, including applying any precursor provided in the first aspect to a surface of a buried interface, and performing an annealing treatment on a resulting product to form a perovskite light-absorbing layer.

In one or more embodiments of this application, a preparation method of a perovskite light-absorbing layer is provided, enabling any precursor provided in the first aspect to form a perovskite light-absorbing layer with good quality and stability.

According to a fourth aspect, this application provides a perovskite battery, including a perovskite light-absorbing layer; where the perovskite light-absorbing layer is the perovskite light-absorbing layer provided in the second aspect or a perovskite light-absorbing layer prepared using the method provided in the third aspect.

In one or more embodiments of this application, a perovskite battery is provided, which includes the perovskite light-absorbing layer provided in the second aspect or a perovskite light-absorbing layer prepared using the method provided in the third aspect, which is conducive to improving the photoelectric conversion efficiency and stability of the perovskite battery, thereby broadening the application prospect of the perovskite battery and improving the commercial value.

According to a fifth aspect, an electric device is provided, including the perovskite battery provided in the fourth aspect.

In one or more embodiments of this application, the perovskite battery serves as a power source for the above electric device to supply power; or the perovskite battery may be used as an energy storage unit of the above electric device. For example, the electric device may be a lighting element, a display element, an automobile, or the like.

### DESCRIPTION OF DRAWINGS

To describe the technical solutions in the embodiments of this application more clearly, the following briefly describes the accompanying drawings required for describing the embodiments of this application. Apparently, the accompanying drawings in the following description show merely some embodiments of this application, and persons of ordinary skill in the art may still derive other drawings from the accompanying drawings without creative efforts.
FIG. 1 is a first schematic structural diagram of a perovskite battery according to this application;
FIG. 2 is a second schematic structural diagram of a perovskite battery according to this application;
FIG. 3 is a third schematic structural diagram of a perovskite battery according to this application;
FIG. 4 is a microscopic morphology diagram of a perovskite light-absorbing layer formed in Example 1;
FIG. 5 is a microscopic morphology diagram of a perovskite light-absorbing layer formed in Example 3; and
FIG. 6 is a microscopic morphology diagram of a perovskite light-absorbing layer formed in Comparative example 1.

In the accompanying drawings, the figures are not necessarily drawn to scale.

Description of reference signs:
100. perovskite battery, 10. conductive substrate, 20. first transport layer, 30. perovskite light-absorbing layer, 40. second transport layer, and 50. metal electrode.

### DETAILED DESCRIPTION

The following further describes implementations of this application in detail with reference to the accompanying drawings and embodiments. The detailed description of the embodiments and the accompanying drawings are intended to illustrate the principle of this application, rather than to limit the scope of this application, meaning this application is not limited to the embodiments described herein.

In the description of this application, it should be noted that, unless otherwise stated, "multiple" means at least two; and the orientations or positional relationships indicated by the terms "upper", "lower", "left", "right", "inside", "outside", and the like are merely for ease and brevity of description of this application rather than indicating or implying that the means or components mentioned must have specific orientations or must be constructed or manipulated according to particular orientations. These terms shall therefore not be construed as limitations on this application. In addition, the terms "first", "second", "third", and the like are merely for the purpose of description and shall not be understood as any indication or implication of relative importance. "Perpendicular" is not strictly perpendicular, but within the allowable range of error. "Parallel" is not strictly parallel, but within the allowable range of error.

The orientation terms appearing in the following description all are directions shown in the figures, and do not limit the specific structure of this application. In the description of this application, it should also be noted that unless otherwise specified and defined explicitly, the terms "mounting", "connection", and "join" should be understood in their general senses. For example, they may refer to a fixed connection, a detachable connection, or an integral connection, and may refer to a direct connection or an indirect connection via an intermediate medium. Persons of ordinary skill in the art can understand specific meanings of these terms in this application as appropriate to specific situations.

At present, there is a technology where the element tin, which is from the same group as the element lead, is used to replace the element lead to form a tin-based perovskite battery. The formed tin-based perovskite battery has lower exciton binding energy, higher optical absorption coefficient and carrier mobility than the lead-based perovskite battery, and is considered a new-generation non-toxic/low-toxic commercial perovskite battery.

However, in addition to the above advantages, the tin-based perovskite battery also has some intrinsic defects that deteriorate its performance. For example, the theoretical valence state of the element tin in the tin-based perovskite should be divalent (that is, Sn²⁺), but Sn²⁺ is easily oxidized to Sn⁴⁺, causing severe self-p-doping, generating numerous tin vacancies, and significantly weakening the stability of the tin-based perovskite. In addition, the reaction rate between the element tin and the organic component is too large, and it is difficult to control the crystallization quality of the element tin and the organic component, leading to many defects and poor quality in the formed tin-based perovskite film, which in turn significantly impacts the photoelectric conversion efficiency and stability of the formed tin-based perovskite battery.

Replacing part of the element lead in a lead-based perovskite material with the element tin to form the perovskite battery is an effective development direction. This can reduce the pollution of the lead-based perovskite battery while ensuring that the photoelectric conversion efficiency and stability of the formed perovskite battery remain at a high level.

However, although the perovskite battery has shown good application potential, it still faces many problems and challenges. First, in the lead-tin mixed perovskite, the intrinsic defect of Sn²⁺ being easily oxidized to Sn⁴⁺ still exists, having a significant impact on the stability of the tin-based perovskite. Second, the tin vacancy defect caused by the introduction of the element tin still exists, and the formed lead-tin mixed perovskite is likely to exhibit a conductor property. Third, the large reaction rate between the element tin and the organic component results in poor crystallization quality of the formed tin-based perovskite component, causing defects such as wrinkles and holes. These defects easily become active sites for charge recombination, charge traps, or charge leakage, leading to a decline in the overall performance of the formed perovskite battery. In addition, the large difference in the crystallization rate between the tin-based perovskite component and the lead-based perovskite component easily causes uneven crystal grain distribution of the tin-based perovskite and lead-based perovskite, thereby deteriorating the quality of the formed lead-tin mixed perovskite film, which in turn affects the photoelectric conversion efficiency of the formed perovskite battery.

Additive engineering can effectively influence the crystallization process and film formation quality of the perovskite film and passivate various defects that may exist during the formation of the perovskite film, thereby improving the photoelectric conversion efficiency and stability of the perovskite battery. This is a simple and efficient means to improve the performance of the perovskite battery.

In summary, in this application, given the above problems of the perovskite battery, during the formation of the lead-tin mixed perovskite light-absorbing layer, an organic additive is introduced to alleviate problems such as an intrinsic defect of Sn²⁺ being easily oxidized to Sn⁴⁺, a tin vacancy defect caused by introduction of the element tin, a crystallization defect of a tin-based perovskite component, and uneven crystal grain distribution of a tin-lead-based perovskite component, thereby improving the photoelectric conversion efficiency and stability of the perovskite battery.

Further, this application provides a small molecule organic additive including one or more functional groups of 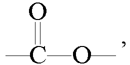 -OH , and -NH2 to participate in the formation of the lead-tin mixed perovskite light-absorbing layer. This organic additive interacts strongly with the tin-based component in the lead-tin mixed perovskite precursor, suppressing impurities in the intermediate phase, reducing the crystal growth rate, and ultimately obtaining a lead-tin mixed perovskite film without holes and wrinkles, thereby improving the photoelectric conversion efficiency and stability of the perovskite battery.

The technical solutions described in the embodiments of this application are applicable to a perovskite battery, a light-absorbing layer and preparation method thereof, and an electric device. The perovskite batteries disclosed in this application can be used in perovskite tandem solar batteries and silicon-perovskite tandem solar batteries, without limitation in this application.

The following describes this application in detail with reference to the accompanying drawings and embodiments.

According to a first aspect, this application provides a precursor for preparing a perovskite light-absorbing layer, including:
a perovskite precursor solution and an organic additive added to the perovskite precursor solution,
where the organic additive includes one or more functional groups of 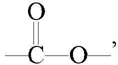 -OH, and -NH2 .

In this application, the "precursor" refers to a precursor product for obtaining the perovskite light-absorbing layer. The "perovskite light-absorbing layer", as the core component of the perovskite battery, is used to absorb photon energy from sunlight, generate electron-hole pairs, and separate the electron-hole pairs into free electrons and holes under the action of a built-in electric field. The holes are collected by a conductive substrate through a hole transport layer, and the electrons are collected by a metal electrode. The conductive substrate and the metal electrode are connected to form a circuit to generate photocurrents. The "perovskite precursor solution" refers to a precursor material for forming a perovskite material. The "organic additive" is added to the perovskite precursor solution to react with a specific component in the lead-tin mixed perovskite precursor, passivating defects during the formation of perovskite. 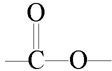 represents a carboxyl group, -OH represents a hydroxyl group, and -NH₂ represents an amino group.

In one or more embodiments of this application, the organic additive including one or more functional groups of the carboxyl group, the hydroxyl group, and the amino group is added to the perovskite precursor solution, alleviating problems such as a crystallization defect and uneven crystal grain distribution of a perovskite component in the process of the perovskite precursor solution forming perovskite, thereby improving the photoelectric conversion efficiency and stability of the perovskite battery.

In some embodiments, the perovskite precursor solution includes a lead-tin mixed perovskite precursor solution.

In this application, the "lead-tin mixed perovskite precursor solution" refers to a precursor material for forming a lead-tin mixed perovskite material.

In one or more embodiments of this application, the organic additive including one or more functional groups of the carboxyl group, the hydroxyl group, and the amino group is added to the lead-tin mixed perovskite precursor solution, alleviating problems such as an intrinsic defect of Sn²⁺ being easily oxidized to Sn⁴⁺, a tin vacancy defect caused by introduction of the element tin, a crystallization defect of a tin-based perovskite component, and uneven crystal grain distribution of a tin-lead-based perovskite component, thereby improving the photoelectric conversion efficiency and stability of the perovskite battery.

Specifically, the organic additive including one or more functional groups of the carboxyl group, the hydroxyl group, and the amino group interacts strongly with the tin-based component in the lead-tin mixed perovskite precursor, suppressing impurities in the intermediate phase, reducing the crystal growth rate, and ultimately obtaining a lead-tin mixed perovskite light-absorbing layer without holes and wrinkles, thereby improving the photoelectric conversion efficiency and stability of the perovskite battery.

In some embodiments, the organic additive includes two functional groups 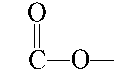 and -OH , or two functional groups 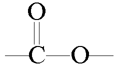 and -NH₂ . The precursor provided in this embodiment can be combined with the precursor provided in any one of the foregoing embodiments.

In one or more embodiments of this application, the organic additive includes two functional groups 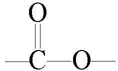 and -OH or two functional groups 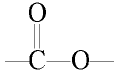 and -NH₂ , to increase the degree of binding and/or coordination between the organic additive and the tin-based component in the perovskite precursor solution, thereby delaying the crystallization process of the lead-tin mixed perovskite and/or passivating defects, forming a high-quality perovskite light-absorbing layer.

In some embodiments, a structural formula of the organic additive includes 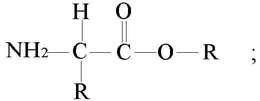 where R includes at least one of H, CH₃, or C₂H₅. The precursor provided in this embodiment can be combined with the precursor provided in any one of the foregoing embodiments.

In one or more embodiments of this application, a chain-structured organic additive is added to the perovskite precursor solution, improving the quality of the formed perovskite light-absorbing layer. Specifically, in one or more embodiments of this application, the organic additive is organic small molecule amine, which can interact strongly with the tin-based component in the lead-tin mixed perovskite precursor, thereby reducing the crystallization rate of the tin-based perovskite component.

In some embodiments, the structural formula of the organic additive includes one or more of 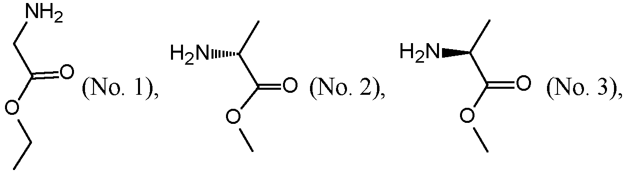 and

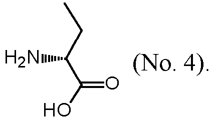

In one or more embodiments of this application, several preferred organic small molecule additives are provided to improve the quality of the perovskite light-absorbing layer. Specifically, the several organic additives provided in one or more embodiments of this application are isomers of C₄H₉O₂N and all have a chain structure. No. 1 includes a terminal amino group; No. 2 and No. 3 are chiral isomers; and No. 4 includes a terminal carboxyl group.

In some embodiments, a structural formula of the organic additive includes 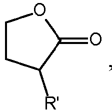 where R' includes NH₂ or OH. The precursor provided in this embodiment can be arbitrarily combined with the precursors provided in the foregoing three embodiments.

In one or more embodiments of this application, a cyclic-structured organic additive is added to the perovskite precursor solution, improving the quality of the formed perovskite light-absorbing layer. Specifically, in one or more embodiments of this application, the organic additive is heterocyclic-structured organic small molecule amine or organic small molecule hydroxyl ester. The strong interaction between the amino group or hydroxyl group of the organic additive and the tin-based component in the lead-tin mixed perovskite precursor reduces the crystallization rate of the tin-based perovskite component.

In some embodiments, the structural formula of the organic additive includes one or more of

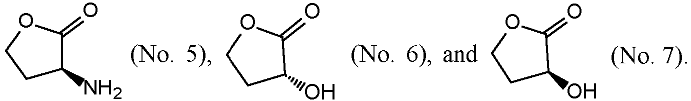

In one or more embodiments of this application, several organic small molecule additives are provided to improve the quality of the perovskite light-absorbing layer. Specifically, the several organic additives provided in one or more embodiments of this application all have oxygen-containing five-membered rings and are aliphatic. No. 5 includes an amino group; and No. 6 and No. 7 both include hydroxyl groups and are chiral isomers.

In some embodiments, the structural formula of the organic additive includes one or more of

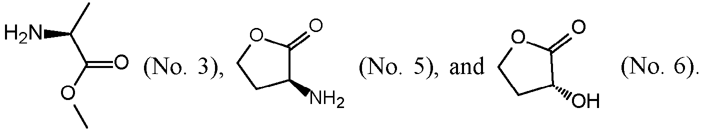

The precursor provided in this embodiment can be arbitrarily combined with the precursor provided in Example 4 or 6.

In one or more embodiments of this application, the foregoing several organic additives reduce the oxidation of Sn²⁺ to Sn⁴⁺, the formation of the tin vacancy defect, and the crystallization rate of the tin-based perovskite component, and improve the quality of the formed perovskite light-absorbing layer, thereby improving the photoelectric conversion efficiency and stability of the perovskite battery.

In some embodiments, the structural formula of the organic additive includes one or more of 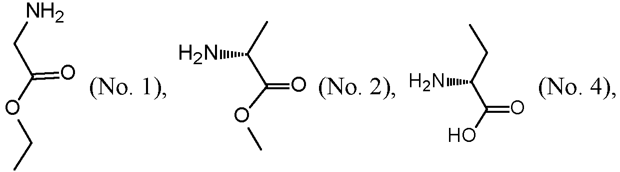 and 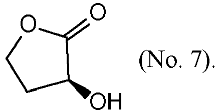 The precursor provided in this embodiment can be arbitrarily combined with the precursor provided in Example 4 or 6.

In one or more embodiments of this application, the foregoing several organic additives further improve the quality of the formed perovskite light-absorbing layer, significantly improving the photoelectric conversion efficiency and stability of the perovskite battery.

In some embodiments, a molar amount of the organic additive is 0.1%-10% of a molar amount of the perovskite precursor solution. The precursor provided in this embodiment can be combined with the precursor provided in any one of the foregoing embodiments.

In one or more embodiments of this application, a proportion of the molar amount of any organic additive that can improve the quality of the formed perovskite light-absorbing layer to the molar amount of the perovskite precursor solution is within the protection scope of this application. In one or more embodiments, the molar amount of the organic additive is within the range of 0.1%-10% of the molar amount of the perovskite precursor solution, resulting in a high-quality perovskite light-absorbing layer, and effectively improving the photoelectric conversion efficiency and stability of the perovskite battery.

For example, the molar amount of the organic additive may be 0.1%, 1%, 2%, 5%, or 10% of the molar amount of the perovskite precursor solution, and may also be 3%, 4%, 6%, 7%, 8%, or 9%, reasonably set as needed.

According to a second aspect, a perovskite light-absorbing layer is provided, prepared from any precursor provided in the first aspect.

In one or more embodiments of this application, the titanium ore light-absorbing layer is prepared from the precursor provided in the first aspect, resulting in improved photoelectric conversion efficiency and stability, thereby prolonging the service life of the perovskite battery including such layer and broadening the application prospect.

In some embodiments, a material of the perovskite light-absorbing layer is CS_{(0-0.05)}FA_{(0.8-0.95)}MA_{(0-0.10)}Pb_{(0.5-1.0)}Sn_{(0.3-0.6)}I₃.

In one or more embodiments of this application, Cs_{(0-0.05)}FA_{(0.8-0.95)}MA_{(0-0.10)}Pb_{(0.5-1.0)}Sn_{(0.3-0.6)}I₃ represents a specific lead-tin mixed perovskite material, where Cs represents the element cesium, FA represents the element formamidinium, MA represents methylammonium, Pb represents the element lead, Sn represents the element tin, and I represents the element iodine.

In this embodiment, the precursor liquid of Cs_{(0-0.05)}FA_{(0.8-0.95)}MA_{(0-0.10)}PbI_{(2.0-2.7)}Br_{(0.3-1.0)} is composed of inorganic cations (Cs⁺, including cases without adding Cs+), formamidinium (FA⁺), methylammonium (MA⁺), divalent metal cations (Pb²⁺, Sn²⁺), and halide anions (I⁻).

In one or more embodiments of this application, the provided organic additive is added to the perovskite precursor solution, such that the organic additive interacts strongly with the tin-based component therein, suppressing impurities in the intermediate phase, and reducing the crystal growth rate, to obtain a perovskite light-absorbing layer without holes and wrinkles, thereby improving the photoelectric conversion efficiency and stability of the perovskite battery.

In some embodiments, a material of the perovskite light-absorbing layer is Cs_{0.05}FA_{0.90}MA_{0.05}Pb_{0.6}Sn_{0.4}I₃. The perovskite light-absorbing layer provided in this embodiment can be arbitrarily combined with any perovskite light-absorbing layer provided in the above embodiments.

In one or more embodiments of this application, a perovskite battery is made of lead-tin mixed perovskite with a specific Sn doping amount. This reduces pollution of the lead-based perovskite battery, decreases intrinsic defects, improves film quality, and ensures that the photoelectric conversion efficiency and stability of the formed perovskite battery remain at a high level. Additionally, during the formation of Cs_{0.05}FA_{0.90}MA_{0.05}Pb_{0.6}Sn_{0.4}I₃, the organic additive provided in this application is added, further improving the photoelectric conversion efficiency and stability of the perovskite battery, such that the perovskite battery provided in this application has significantly improved photoelectric conversion efficiency and stability.

A third aspect of this application provides a preparation method of a perovskite light-absorbing layer, including: applying any precursor provided in the first aspect to a surface of a buried interface, and performing an annealing treatment on a resulting product to form a perovskite light-absorbing layer.

In one or more embodiments of this application, the "buried interface" represents the supporting structure for forming the perovskite light-absorbing layer. In one or more embodiments of this application, the buried interface may be an electron transport layer or a hole transport layer. The "annealing treatment" refers to a heat treatment process where the material is exposed to high temperature for a period and then slowly cooled. In some embodiments, the process parameters of the annealing treatment of one or more embodiments of this application are as follows: a temperature of 100°C-150°C and 10 min-30 min for a heat preservation treatment.

In one or more embodiments of this application, a preparation method of a perovskite light-absorbing layer is provided, enabling any precursor provided in the first aspect to form a perovskite light-absorbing layer with good quality and stability.

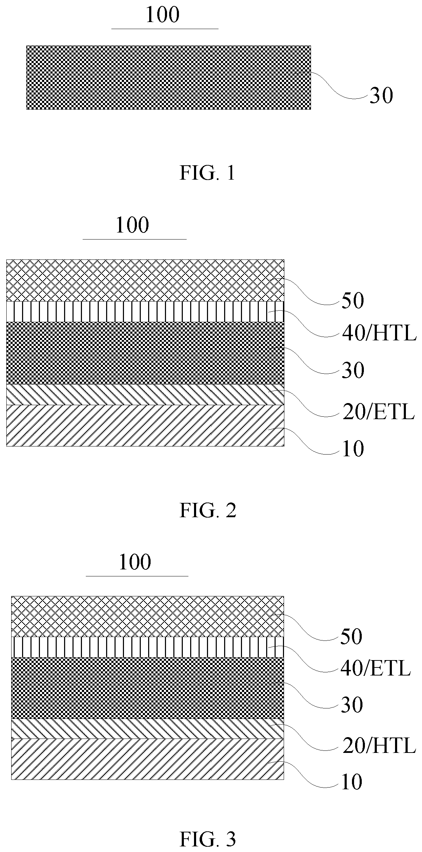

Referring to FIGs. 1 to 3, FIG. 1 is a first schematic structural diagram of a perovskite battery according to this application; FIG. 2 is a second schematic structural diagram of a perovskite battery according to this application; and FIG. 3 is a third schematic structural diagram of a perovskite battery according to this application.

According to a fourth aspect, referring to FIG. 1, this application provides a perovskite battery 100, including a perovskite light-absorbing layer 30. The perovskite light-absorbing layer 30 is the perovskite light-absorbing layer 30 provided in the second aspect or a perovskite light-absorbing layer 30 prepared using the method provided in the third aspect.

In one or more embodiments of this application, the "perovskite battery 100" represents a perovskite battery that uses a lead-tin mixed perovskite material as a light-absorbing layer material.

In one or more embodiments of this application, a perovskite battery 100 is provided, which includes the perovskite light-absorbing layer 30 provided in the second aspect or a perovskite light-absorbing layer 30 prepared using the method provided in the third aspect, which is conducive to improving the photoelectric conversion efficiency and stability of the perovskite battery 100, thereby broadening the application prospect of the perovskite battery 100 and improving the commercial value.

In some embodiments, the perovskite battery 100 includes a conductive substrate 10, a first transport layer 20, a perovskite light-absorbing layer 30, a second transport layer 40, and a metal electrode 50 that are stacked in sequence. One of the first transport layer 20 and the second transport layer 40 is a hole transport layer (HTL), and the other is an electron transport layer (ETL).

In one or more embodiments of this application, the "conductive substrate 10" represents an electrode with high conductivity and high visible light transmittance, serving as one output terminal of the perovskite battery 100, such as ITO conductive glass or FTO conductive glass. The "first transport layer 20" and "second transport layer 40" represent structural layers that transport electrons or holes generated by the perovskite light-absorbing layer 30 upon photon excitation. The "hole transport layer (HTL)", as an important component of the perovskite battery 100, mainly functions to collect and transport holes, achieving effective separation of electrons and holes. The "electron transport layer (ETL)", also known as the electron collection layer, plays an important role in transporting electrons and blocking electron-hole recombination. The "metal electrode 50" represents an electrode made of a metal material, serving as another output terminal of the perovskite battery 100 component, and requiring high conductivity and stability.

In one or more embodiments of this application, referring to FIG. 2, when the first transport layer 20 is an electron transport layer (ETL) and the second transport layer 40 is a hole transport layer (HTL), the perovskite battery 100 containing both is a normal component.

In one or more embodiments of this application, referring to FIG. 3, when the first transport layer 20 is a hole transport layer (HTL) and the second transport layer 40 is an electron transport layer (ETL), the perovskite battery 100 containing both is an inverted component.

According to a fifth aspect, this application provides an electric device, including the perovskite battery 100 provided in the fourth aspect.

In one or more embodiments of this application, the perovskite battery 100 serves as a power source for the above electric device to supply power; or the perovskite battery 100 may be used as an energy storage unit of the above electric device. For example, the electric device may be a lighting element, a display element, an automobile, or the like.

This application provides organic additives No. 1 to No. 9, used for preparing corresponding perovskite batteries 100, and chemical structural formulas of the organic additives No. 1 to No. 9 are shown in Table 1.

**Table 1 Chemical structural formulas of organic additives No. 1 to No. 15**

| Item | Chemical structural formula | Item | Chemical structural formula |
|---|---|---|---|
| No. 1 | 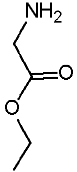 | No. 6 | 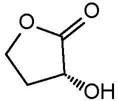 |
| No. 2 | 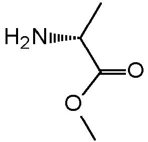 | No. 7 | 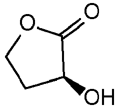 |
| No. 3 | 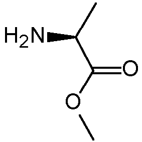 | No. 8 | 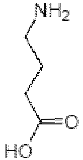 |
| No. 4 | 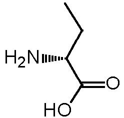 | No. 9 | 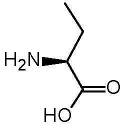 |
| No. 5 | 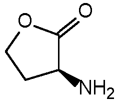 | | |

### Example 1

This example provided a preparation method of the perovskite battery 100 in FIG. 3, including the following steps:
Step (1): A conductive substrate 10 was cleaned, and then a first transport layer 20 with a thickness of 30 nm was formed on the cleaned surface of the conductive substrate 10 by magnetron sputtering. In this example, the first transport layer 20 was a hole transport layer (HTL).
Step (2): An organic additive No. 1 was added to a lead-tin mixed perovskite precursor solution forming Cs_{0.05}FA_{0.90}MA_{0.05}Pb_{0.6}Sn_{0.4}I₃. In this example, a concentration of the perovskite precursor solution was 1.3 M, and a molar amount of the organic additive No. 1 was 5% of a molar amount of the perovskite precursor solution. The surface of the first transport layer 20 was spin-coated with the perovskite precursor solution including the added organic additive No. 1 and annealed at 120°C for 30 min to form a perovskite light-absorbing layer 30 with a thickness of 450 nm.
Step (3): The surface of the perovskite light-absorbing layer 30 was spin-coated with PCBM (fullerene) and BCP (bathocuproine, a hole-blocking material) to form an electron transport layer (ETL) with a thickness of 30 nm that served as a second transport layer 40.
Step (4): A metal silver electrode with a thickness of 100 nm was thermally evaporated on the surface of the second transport layer 40 away from the conductive substrate 10, and served as a metal electrode 50.

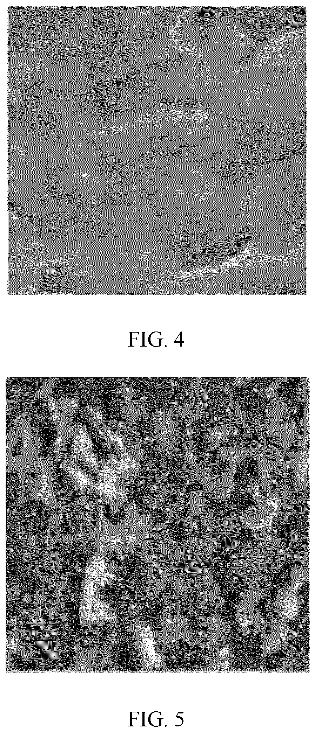

The microscopic morphology of the perovskite light-absorbing layer 30 formed in this example is shown in FIG. 4. The perovskite light-absorbing layer 30 formed in this example had a smooth, complete surface without wrinkles, and with a small amount of holes and impurities.

### Example 2

The preparation method of the perovskite battery 100 provided in this example differed from that in Example 1 in that:
an organic additive No. 2 was used in step (2).

The rest was the same as that in Example 1.

### Example 3

The preparation method of the perovskite battery 100 provided in this example differed from that in Example 1 in that:
an organic additive No. 3 was used in step (2).

The rest was the same as that in Example 1.

The microscopic morphology of a perovskite light-absorbing layer 30 formed in this example is shown in FIG. 5 As can be seen from FIG. 5, the perovskite light-absorbing layer 30 formed in this example had a rough surface with many small particles and obvious wrinkles, but a small amount of holes, and the film still had overall integrity.

### Example 4

The preparation method of the perovskite battery 100 provided in this example differed from that in Example 1 in that:
an organic additive No. 4 was used in step (2).

The rest was the same as that in Example 1.

### Example 5

The preparation method of the perovskite battery 100 provided in this example differed from that in Example 1 in that:
an organic additive No. 5 was used in step (2).

The rest was the same as that in Example 1.

### Example 6

The preparation method of the perovskite battery 100 provided in this example differed from that in Example 1 in that:
an organic additive No. 6 was used in step (2).

The rest was the same as that in Example 1.

### Example 7

The preparation method of the perovskite battery 100 provided in this example differed from that in Example 1 in that:
an organic additive No. 7 was used in step (2).

The rest was the same as that in Example 1.

### Comparative example 1

The preparation method of the perovskite battery 100 provided in this comparative example differed from that in Example 1 in that:
an organic additive No. 8 was used in step (2).

The rest was the same as that in Example 1.

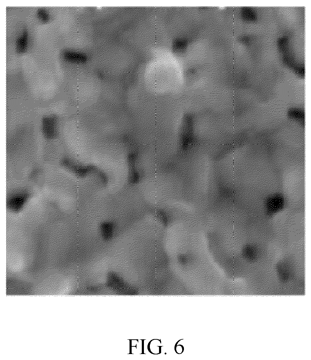

The microscopic morphology of a perovskite light-absorbing layer 30 formed in this comparative example is shown in FIG. 6 As can be seen from FIG. 6, the perovskite light-absorbing layer 30 formed in this example had a rough surface with many holes and obvious wrinkles, and the film had poor integrity.

### Comparative example 2

The preparation method of the perovskite battery 100 provided in this comparative example differed from that in Example 1 in that:
an organic additive No. 9 was used in step (2).

The rest was the same as that in Example 1.

### Comparative example 3

The preparation method of the perovskite battery 100 provided in this comparative example differed from that in Example 1 in that:

No organic additive was added in step (2).

The rest was the same as that in Example 1.

### Experimental example

The photoelectric conversion efficiency and stability of the perovskite batteries 100 prepared in Examples 1 to 7 were tested, and the test results are shown in Table 2.

In this example, the photoelectric conversion efficiency of the perovskite batteries 100 was tested according to the IEC61215 standard. The stability was derived from the change rate of the photoelectric conversion efficiency after aging at 85°C for 72 h.

**Table 2 Performance test results of perovskite batteries 100 in examples**

| Item | Photoelectric conversion efficiency | Change rate of photoelectric conversion efficiency after aging at 85°C for 72 h. |
|---|---|---|
| Example 1 | 19.04% | -22% |
| Example 2 | 19.2% | -19% |
| Example 3 | 17.6% | -35% |
| Example 4 | 19.2% | -20% |
| Example 5 | 17.28% | -33% |
| Example 6 | 17.92% | -32% |
| Example 7 | 19.52% | -15% |
| Comparative example 1 | 14.4% | -55% |
| Comparative example 2 | 14.88% | -48% |
| Comparative example 3 | 16% | -70% |

According to the test results in Table 2, the following conclusions can be drawn:
(1) Through comparison of the test results between Example 1 and Comparative example 1, it can be known that the amino functional group in the organic additive has a greater influence on the performance of the perovskite battery 100 than the carboxyl functional group, and the carbon chain connected to the amino functional group in the organic additive cannot exceed a certain range; otherwise, the performance of the perovskite battery 100 would deteriorate. This may be because if the carbon chain connected to the amino functional group in the organic additive exceeds a certain range, it is difficult to suppress the crystallization rate of the tin-based perovskite component, leading to a crystallization defect in the tin-based perovskite component and uneven crystal grain distribution in the tin-lead-based perovskite component, thus deteriorating the photoelectric conversion efficiency and stability of the perovskite battery 100.
(2) Through comparison of the test results between Example 4 and Comparative example 2, Example 2 and Example 3, Example 6 and Example 7, as well as Example 4 and Example 9, it can be known that the chiral configuration of the organic additive has a direct influence on the photoelectric conversion efficiency and stability of the perovskite battery 100. This may be because chiral isomers affect the binding of the organic additive to the tin-based component in the lead-tin mixed perovskite precursor, which in turn affects the function of the organic additive on the perovskite light-absorbing layer 30, thereby impacting the photoelectric conversion efficiency and stability of the perovskite battery 100.
(3) Through comparison of the test results between Examples 1 to 7 and Comparative example 3, it can be known that the addition of the organic additives No. 1 to 7 during the preparation of the perovskite light-absorbing layer 30 improves the photoelectric conversion efficiency and stability of the perovskite battery 100 to a certain extent. This may be because the organic additives No. 1 to 7 are added to strongly interact with the tin-based component in the lead-tin mixed perovskite precursor, suppressing impurities in the intermediate phase, reducing the crystal growth rate, and improving the photoelectric conversion efficiency and stability of the perovskite battery 100.
(4) Through comparison of the test results between Examples 3, 5, and 6, it can be known that the addition of the organic additive No. 3, 5, or 6 during the preparation of the perovskite light-absorbing layer 30 slightly improves the photoelectric conversion efficiency and stability of the perovskite battery 100. This may be because the addition of the organic additive No. 3, 5, or 6 can reduce the oxidation of Sn²⁺ to Sn⁴⁺ and the formation of the tin vacancy defect, reduce the crystallization rate of the tin-based perovskite component, and improve the quality of the formed perovskite light-absorbing layer 30.
(5) Through comparison of the test results between Examples 1, 2, 4, and 7, it can be known that the addition of the organic additive No. 1, 2, 4, or 7 during the preparation of the perovskite light-absorbing layer 30 significantly improves the photoelectric conversion efficiency and stability of the perovskite battery 100. This may be because the addition of the organic additive No. 1, 2, 4, or 7 can further improve the quality of the formed perovskite light-absorbing layer 30, thus significantly improving the photoelectric conversion efficiency and stability of the perovskite battery 100.

Although this application has been described with reference to preferred embodiments, various modifications can be made and the components therein can be replaced by equivalents without departing from the scope of this application. In particular, as long as there is no structural conflict, the technical features mentioned in the various embodiments can be combined in any manner. This application is not limited to the specific embodiments disclosed in this specification but includes all technical solutions falling within the scope of the claims.

## Claims

1. A precursor for preparing a perovskite light-absorbing layer, comprising
a perovskite precursor solution and an organic additive added to the perovskite precursor solution;
wherein the organic additive comprises one or more functional groups of 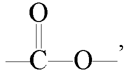 -OH, and -NH2 .

2. The precursor according to claim 1, wherein the perovskite precursor solution comprises a lead-tin mixed perovskite precursor solution.

3. The precursor according to claim 1 or 2, wherein the organic additive comprises two functional groups 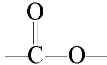 and -QH , or two functional groups 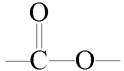 and -NH₂.

4. The precursor according to any one of claims 1 to 3, wherein a structural formula of the organic additive comprises: 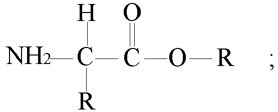 wherein R comprises at least one of H, CH₃, or C₂H₅.

5. The precursor according to claim 4, wherein the structural formula of the organic additive comprises one or more 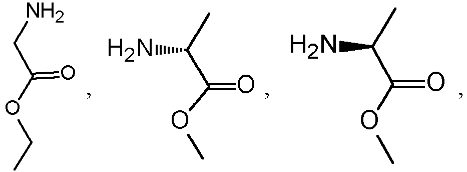 and

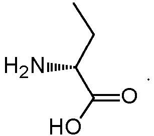

6. The precursor according to any one of claims 1 to 3, wherein a structural formula of the organic additive comprises: 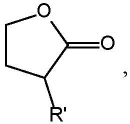 wherein R' comprises NH₂ or OH.

7. The precursor according to claim 6, wherein the structural formula of the organic additive comprises one or more of

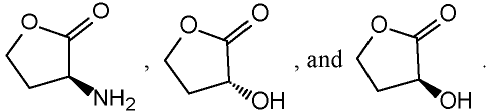

8. The precursor according to claim 4 or 6, wherein the structural formula of the organic additive comprises one or more of 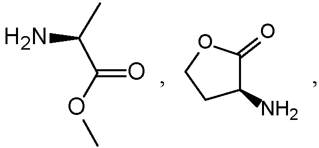 and

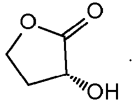

9. The precursor according to claim 4 or 6, wherein the structural formula of the organic additive comprises one or more of 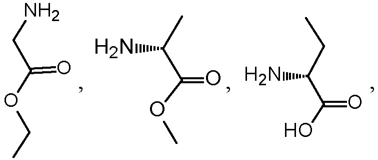 and

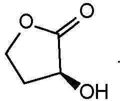

10. The precursor according to any one of claims 1 to 9, wherein a molar amount of the organic additive is 0.1%-10% of a molar amount of the perovskite precursor solution.

11. A perovskite light-absorbing layer, prepared from the precursor according to any one of claims 1 to 10.

12. The perovskite light-absorbing layer according to claim 11, wherein a material of the perovskite light-absorbing layer is Cs_{(0-0.05)}FA_{(0.8-0.95)}MA_{(0-0.10)}Pb_{(0.5-1.0)}Sn_{(0.3-0.6)}I₃.

13. The perovskite light-absorbing layer according to claim 11 or 12, wherein the material of the perovskite light-absorbing layer is Cs_{0.05}FA_{0.90}MA_{0.05}Pb_{0.6}Sn_{0.4}I₃.

14. A preparation method of a perovskite light-absorbing layer, comprising: applying the precursor according to any one of claims 1 to 10 to a surface of a buried interface, and performing an annealing treatment on a resulting product to form a perovskite light-absorbing layer.

15. A perovskite battery, comprising a perovskite light-absorbing layer, wherein the perovskite light-absorbing layer comprises the perovskite light-absorbing layer according to any one of claims 11 to 13 or a perovskite light-absorbing layer prepared using the method according to claim 14.

16. An electric device, wherein the electric device comprises the perovskite battery according to claim 15.
